# EUROPEAN PATENT SPECIFICATION

(11) **EP 3 700 316 B1**
(45) Date of publication and mention of the grant of the patent: **02.09.2026**
(21) Application number: 18868236.3
(22) Date of filing: 27.04.2018
(51) Int. Cl.: H05K 9/00, B60L 53/12, B60L 53/38, H02J 50/70, H02M 1/44

(54) **DYNAMIC ACTIVE FLUX LEAKAGE SHIELDING DEVICE AND METHOD**
VORRICHTUNG UND VERFAHREN ZUR DYNAMISCHEN AKTIVEN FLUSSLECKABSCHIRMUNG
DISPOSITIF ET PROCÉDÉ DE PROTECTION ACTIVE DYNAMIQUE CONTRE LES FUITES DE FLUX

(30) Priority: 19.10.2017 CN 201710996902
(43) Date of publication of application: 26.08.2020
(73) Proprietor: NIO (Anhui) Holding Co., Ltd., Hefei City, Anhui Province (CN)
(72) Inventor: CHEN, Xiaoyu, Shanghai (CN); TAN, Guangzhi, Shanghai (CN); GUO, Lei, Shanghai (CN); ZHU, Yue, Shanghai (CN)
(74) Representative: Vossius & Partner Patentanwälte Rechtsanwälte mbB
(86) International application number: PCT/CN2018/084892
(87) International publication number: WO 2019/076024

(56) References cited:
- CN-A- 104 023 512
- CN-A- 105 405 622
- CN-A- 106 899 086
- CN-U- 202 189 097
- CN-U- 204 119 720
- US-A1- 2014 246 916
- US-A1- 2017 179 731

## Description

### Field of the Invention

The present invention relates to the technical field of wireless charging, in particular to a dynamic active magnetic flux leakage shielding device and method.

### Background of the Invention

The rapid development of electric vehicles has put forward higher requirements for charging facilities. At present, traditional wired cables are applied in the transmission of power of no matter DC charging piles or AC charging piles, in high-power occasions, the sizes, prices and weights of the cables may become unbearable, the emergence of wireless charging technology (WPT) can better solve the above problems, and the energy is transmitted through non-contact long-distance transmission, so that the wireless charging technology greatly expands the application occasions of electrical energy transmission and is an energy transmission mode with a broad development prospect. However, while the WPT brings convenience, it also introduces new problems, since the nature of wireless charging is to transmit energy by the magnetic coupling between coils, primary and secondary coils are often connected in a loose coupling manner, which generates greater magnetic flux leakage fields, these magnetic flux leakage fields cause greater pollution to the surrounding environments, especially to people and animals, and these kinds of pollution cannot be ignored and affects the promotion and use of wireless charging.

There are two types of methods for suppressing the magnetic flux leakage fields commonly used in the prior art, that is, active shielding and passive shielding, a similar passive magnetic core is applied in the passive shielding, when the magnetic flux leakage field passes through a shield and generates a reverse electromotive force therein, a current loop is formed to counteract the magnetic leakage flux. The maximal defect is that the magnetic flux leakage shielding ability is weak, the magnetic flux leakage shielding ability is related to the structure of the shield, and once the structure is fixed, it cannot be adjusted.

Chinese patents CN201420287027.9 and CN201410239535.4 disclose a passive shielding solution, which counteract the magnetic leakage flux by adding a compensation capacitor, but the disadvantage is that the introduction of capacitor increases the complexity of the system while increasing the cost.

A method and an apparatus for wireless power transfer and particularly active cancellation of undesirable electric or magnetic field emissions from a wireless power transmitter are known from US 2014/246916 A1. The apparatus includes a sensor, controller, and emitter, wherein the sensor is used to sense the electric or magnetic field emissions from a transmit antenna, the controller configured to determine the undesirable components of the field, and the emitter to generate a field to destructively interfere with the undesirable components.

### Summary of the Invention

The purpose of the present invention is to provide a dynamic active magnetic flux leakage shielding device according to claim 1, which dynamically realizes the adjustment of magnetic flux leakage, and greatly reduces the emission of magnetic flux leakage without affecting the transmission power and efficiency of a wireless magnetic field.

The purpose of the present invention is achieved by the following technical solutions.

The present invention provides a dynamic active magnetic flux leakage shielding device, including: a magnetic field detection unit, an excitation source and an excitation coil, wherein the magnetic field detection unit is configured to detect magnetic flux leakage field intensity and obtain a magnetic flux leakage field compensation value; and the excitation source is configured to drive the excitation coil to generate a magnetic field of the compensation value to counteract a magnetic flux leakage field.

Further, the magnetic field detection unit includes a magnetic field intensity detection coil and a microprocessor, the magnetic field intensity detection coil is configured to detect the magnetic flux leakage field intensity, and the microprocessor is configured to calculate the corresponding magnetic flux leakage field compensation value according to the detected magnetic flux leakage field intensity.

Further, the microprocessor is further configured to judge whether the detected magnetic flux leakage field intensity exceeds a set value, and if the detected magnetic flux leakage field intensity exceeds the set value, start the excitation source to drive the excitation coil to generate the magnetic field of the compensation value to counteract the magnetic flux leakage field.

Further, the microprocessor is further configured to perform weighted average calculation on the magnetic flux leakage field intensity detected by multiple detection points to obtain the magnetic flux leakage field compensation value.

Further, at least one magnetic field intensity detection coil is arranged at the edge of a magnetic flux leakage field transmitting coil.

Further, two magnetic field intensity detection coils are respectively arranged on the both sides of the magnetic flux leakage field transmitting coil.

Further, the excitation source includes a voltage source and/or a current source.

The present invention also provides a dynamic active magnetic flux leakage field compensation method according to claim 6, including: detecting the magnetic flux leakage field intensity around the wireless charging device; calculating a magnetic flux leakage field compensation value according to the magnetic flux leakage field intensity; and judging whether the detected magnetic flux leakage field intensity is higher than a set value of magnetic flux leakage field, and if the detected magnetic flux leakage field intensity exceeds the set value, generating a compensation magnetic field according to the magnetic flux leakage field compensation value to counteract a magnetic flux leakage field.

The above method further includes: after the compensation magnetic field is generated, detecting the magnetic flux leakage field intensity in real time, and dynamically adjusting the intensity of the compensation magnetic field according to the magnetic flux leakage field intensity.

The above method further includes: detecting the magnetic flux leakage field intensity of multiple detection points around the wireless charging device, calculating a weighted average thereof, and using the weighted average to calculate the magnetic flux leakage field compensation value.

The present invention further includes a controller according to claim 9, including a memory and a processor, wherein the memory stores a computer program, and the program can implement the steps of the foregoing method when executed by the processor.

The present invention further includes a computer-readable storage medium according to claim 10 for storing computer instructions, wherein the instructions implement the steps of the foregoing method when executed by a computer or a processor.

Through the dynamic active magnetic flux leakage shielding device and method provided by the present invention, dynamic adjustment of magnetic flux leakage can be realized, and the emission of the magnetic flux leakage can be greatly reduced without affecting the transmission power and efficiency of the wireless magnetic field, thereby reducing the influence of magnetic flux leakage radiation on human body. In addition, in the present invention, only a few components for measuring the field intensity, the excitation coil and the processor need to be added, so that the problem of shielding the magnetic flux leakage field can be solved with less cost, and the economical efficiency is better

### Brief Description of the Drawings

Fig. 1 is a structural schematic diagram of an embodiment of a dynamic active magnetic flux leakage shielding device in the present invention.
Fig. 2 is a working flow diagram of a dynamic active magnetic flux leakage shielding device in the present invention.

### Main reference signs:

| | | | |
|---|---|---|---|
| 1- | input end coil | 2- | output end coil |
| 3- | magnetic field intensity detection coil | 4- | microprocessor |
| 5- | excitation source | 6- | magnetic flux leakage field shielding coil |

### (also called an excitation coil)

### Detailed Description of the Embodiments

The present invention is described in further detail below through specific embodiments in combination with drawings.

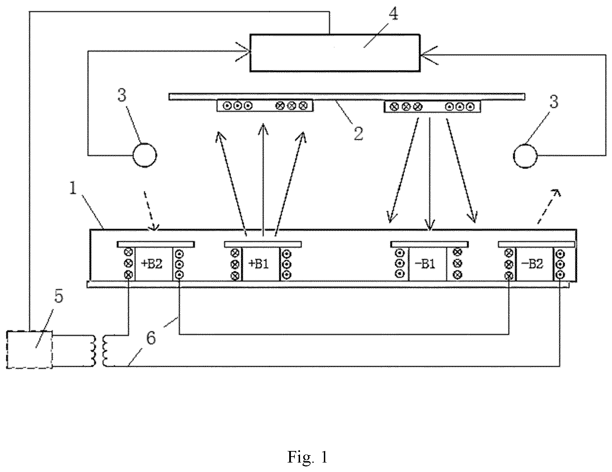

As shown in Fig. 1, the present embodiment provides a dynamic active magnetic flux leakage shielding device. The device is an active magnetic flux leakage shielding device that shields a magnetic flux leakage field through the principle of positive and negative cancellation based on a magnetic field intensity vector H.

1 and 2 in the device respectively represent an input end coil and an output end coil in an electric vehicle wireless charging structure, and a magnetic coupling structure thereof can be DD structure and can also be a DDQ structure or other suitable coupling structures; 6 represents a magnetic flux leakage field shielding coil (also called an excitation coil), which is installed on both sides of a main coil 1; 5 represents an excitation source, which is configured to drive the magnetic flux leakage field shielding coil; the excitation source 5 can be a voltage source or a current source; 4 represents a microprocessor, which is configured to control the excitation source 5; and 3 represents a magnetic field intensity detection coil for detecting the magnetic field intensity, which is generally arranged on the edge of a transmitting coil and is respectively arranged on the both sides of the main coil 1 in the present embodiment to detect the magnetic flux leakage field intensity. Since the magnetic fields generated by the magnetic flux leakage field shielding coil 6 and the main coil 1 are equal in size and opposite in directions, the magnetic flux leakage field can be completely counteracted, so the magnetic field can be confined within a very small range.

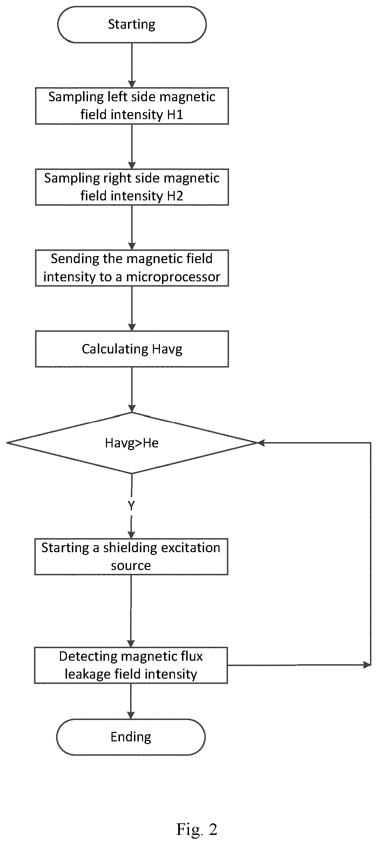

As shown in Fig. 1 and Fig. 2, the magnetic field intensity detection coil 3 collects left side magnetic field intensity H1 and right side magnetic field intensity H2, and sends the collected magnetic field intensity H1 and H2 to the microprocessor 4, and the microprocessor 4 calculates an average value Havg of H1 and H2 to serve as a magnetic flux leakage field compensation value, and judges whether Havg is greater than a magnetic flux leakage intensity set value He. If so, the excitation source 5 is started to drive the magnetic flux leakage field shielding coil 6 to generate a compensation magnetic field opposite to Havg to counteract the magnetic flux leakage field. After the compensation magnetic field comes into play, the microprocessor continuously detects and judges whether the Havg of the magnetic flux leakage field is greater than the magnetic flux leakage intensity set value He, and dynamically adjusts the intensity of the compensation magnetic field.

In one embodiment of the present invention, in order to achieve the accurate measurement of the magnetic flux leakage field, two magnetic field intensity detection coils 3 are provided for detecting the field intensity at key positions, and are respectively placed at places where the magnetic flux leakage is strongest. The magnetic field intensity detection coil 3 can be made into an antenna shape once the magnetic field intensity is detected to exceed certain intensity, the microprocessor 4 issues a command to drive the magnetic flux leakage field shielding coil 6 to generate the compensation magnetic field, which has the same size as the magnetic flux leakage field, but has an opposite direction, so as to eliminate the influence of the magnetic flux leakage on human body and the surrounding environment.

The process of generating the compensation magnetic field is further described below through specific embodiments.

It is assumed that a set value of magnetic flux leakage field intensity is H0, and the magnetic field intensity detection coil detects the magnetic field intensity H1. Firstly, a magnetic field signal is converted into electric quantity by an attached sensor for subsequent processing. Then, logical subtraction is performed by the microprocessor on the initial set value H0 of magnetic flux leakage field intensity and the detected actual magnetic field intensity H1 to obtain DeltaH = HO-H1. Then, parameters such as the intensity and direction of the compensation magnetic field are adjusted through a PI control loop, and the calculation formula of a regulating variable Control Value is as follows: $Control Value = Kp * \left(H0-H1\right) + Ki * \left(H0-H1\right) ,$

Kp and Ki represent parameters of the PI control loop. Finally, an excitation source is driven by the regulating variable Control Value to generate a suitable compensation magnetic field.

In one embodiment of the present invention, in order to achieve a better result, some more magnetic field detection units can be placed, and multiple pieces of field intensity at different points can be obtained by measurement, that is, H1, H2, H3, ..., Hn. Then, a weighted average is taken to obtain Havg: $Havg = \left(K0*H1+K1*H2+… ..+Kn*Hn\right) / n ;$

Finally, the regulating variable is calculated by using the Havg, and the excitation source is driven to obtain the suitable compensation magnetic field.

The magnetic flux leakage field intensity can be better reduced by uniformly distributing the magnetic field detection units at multiple points. The number of the magnetic field detection units can be 1, 2, 4, or any other number.

According to the dynamic active magnetic leakage shielding device provided by one embodiment of the present invention, by adding the magnetic field detection unit, the excitation coil (the magnetic flux leakage field shielding coil) and the excitation source at key positions, sending the signal collected by the magnetic field detection unit to the microprocessor, calculating the corresponding compensation value for the detected magnetic field intensity and adding the excitation source to the excitation coil, an opposite magnetic field is generated to counteract the magnetic flux leakage field. The shielding of the magnetic flux is only for the magnetic flux leakage field, the main magnetic flux is not obviously counteracted, and the influence of the magnetic flux leakage radiation on the human body can be greatly reduced without affecting the transmission efficiency and power.

Compared with the existing passive shielding or unshielded wireless charging, the biggest advantage of the solution is that it can dynamically adjust the magnetic flux leakage and accurately counteract the magnetic flux leakage field, and is not limited by the structure, thereby greatly improving the safety and convenience.

The dynamic active magnetic flux leakage shielding device provided in the present embodiment requires only a few components for measuring the field intensity, the excitation coil and the microprocessor, so that the problem of magnetic field leakage shielding can be solved with less cost, and the economical efficiency is better.

The above descriptions are only the preferred embodiments of the present invention and are not intended to limit the present invention. For those skilled in the art, the present invention may have various modifications and changes. Any modifications, equivalent replacements, improvements and the like made within the scope limited by the attached claims shall still fall within the protection scope of the present invention.

## Claims

1. An dynamic active magnetic flux leakage shielding device, comprising: a magnetic field detection unit, an excitation source (5) and an excitation coil (6), wherein the magnetic field detection unit is configured to detect magnetic flux leakage field intensity and obtain a magnetic flux leakage field compensation value; and the excitation source (5) is configured to drive the excitation coil (6) to generate a magnetic field of the compensation value to counteract a magnetic flux leakage field,
wherein the magnetic field detection unit comprises a magnetic field intensity detection coil (3) and a microprocessor (4), the magnetic field intensity detection coil (3) is configured to detect the magnetic flux leakage field intensity, and the microprocessor (4) is configured to calculate the corresponding magnetic flux leakage field compensation value according to the detected magnetic flux leakage field intensity,
**characterized in that**
the microprocessor (4) is further configured to judge whether the detected magnetic flux leakage field intensity exceeds a set value, and if the detected magnetic flux leakage field intensity exceeds the set value, start the excitation source (5) to drive the excitation coil (6) to generate the magnetic field of the compensation value to counteract the magnetic flux leakage field.

2. The dynamic active magnetic flux leakage shielding device according to claim 1, wherein the microprocessor (4) is further configured to perform weighted average calculation on the magnetic flux leakage field intensity detected by multiple detection points to obtain the magnetic flux leakage field compensation value.

3. The dynamic active magnetic flux leakage shielding device according to claim 1, wherein at least one magnetic field intensity detection coil (3) is arranged at the edge of a magnetic flux leakage field transmitting coil.

4. The dynamic active magnetic flux leakage shielding device according to claim 3, wherein two magnetic field intensity detection coils (3) are respectively arranged on the both sides of the magnetic flux leakage field transmitting coil.

5. The dynamic active magnetic flux leakage shielding device according to claim 1, wherein the excitation source (5) comprises a voltage source and/or a current source.

6. A dynamic active magnetic flux leakage field compensation method, comprising the following steps:
detecting the magnetic flux leakage field intensity around the wireless charging device;
calculating a magnetic flux leakage field compensation value according to the magnetic flux leakage field intensity; and
judging whether the detected magnetic flux leakage field intensity is higher than a set value of magnetic flux leakage field, and if the detected magnetic flux leakage field intensity exceeds the set value, generating a compensation magnetic field according to the magnetic flux leakage field compensation value to counteract a magnetic flux leakage field.

7. The dynamic active magnetic flux leakage field compensation method according to claim 6, further comprising: after the compensation magnetic field is generated, detecting the magnetic flux leakage field intensity in real time, and dynamically adjusting the intensity of the compensation magnetic field according to the magnetic flux leakage field intensity.

8. The dynamic active magnetic flux leakage field compensation method according to claim 6, further comprising: detecting the magnetic flux leakage field intensity of multiple detection points around the wireless charging device, calculating a weighted average thereof, and using the weighted average to calculate the magnetic flux leakage field compensation value.

9. A controller, comprising a memory and a processor, wherein the memory stores a computer program, and the program can implement the steps of the method according to any of claims 6-8 when executed by the processor.

10. A computer-readable storage medium for storing computer instructions, wherein the instructions implement the steps of the method according to any of claims 6-8 when executed by a computer or a processor.

## Patentansprüche

1. Dynamische aktive Abschirmvorrichtung für magnetisches Streufeld, umfassend: eine Magnetfelderfassungseinheit, eine Anregungsquelle (5) und eine Anregungsspule (6), wobei die Magnetfelderfassungseinheit ausgelegt ist, eine magnetische Streufeldintensität zu erfassen und einen Kompensationswert für das magnetische Streufeld zu erhalten; und wobei die Anregungsquelle (5) ausgelegt ist, die Anregungsspule (6) anzutreiben, um ein Magnetfeld mit dem Kompensationswert zu erzeugen, um einem magnetischen Streufeld entgegenzuwirken,
wobei die Magnetfelderfassungseinheit eine Magnetfeldintensitäts-Erfassungsspule (3) und einen Mikroprozessor (4) umfasst, wobei die Magnetfeldintensitäts-Erfassungsspule (3) ausgelegt ist, die magnetische Streufeldintensität zu erfassen, und wobei der Mikroprozessor (4) ausgelegt ist, den entsprechenden Kompensationswert für das magnetische Streufeld gemäß der erfassten magnetischen Streufeldintensität zu berechnen,
**dadurch gekennzeichnet, dass**
der Mikroprozessor (4) ferner ausgelegt ist, zu beurteilen, ob die erfasste magnetische Streufeldintensität einen Sollwert überschreitet, und, wenn die erfasste magnetische Streufeldintensität den Sollwert überschreitet, die Anregungsquelle (5) zu starten, um die Anregungsspule (6) anzutreiben, um das Magnetfeld mit dem Kompensationswert zu erzeugen, um dem magnetischen Streufeld entgegenzuwirken.

2. Dynamische aktive Abschirmvorrichtung für magnetisches Streufeld nach Anspruch 1, wobei der Mikroprozessor (4) ferner ausgelegt ist, eine gewichtete Mittelwertberechnung der durch mehrere Detektionspunkte erfassten magnetischen Streufeldintensität durchzuführen, um den Kompensationswert für das magnetische Streufeld zu erhalten.

3. Dynamische aktive Abschirmvorrichtung für magnetisches Streufeld nach Anspruch 1, wobei mindestens eine Magnetfeldintensitäts-Erfassungsspule (3) am Rand einer das magnetische Streufeld übertragenden Spule angeordnet ist.

4. Dynamische aktive Abschirmvorrichtung für magnetisches Streufeld nach Anspruch 3, wobei zwei Magnetfeldintensitäts-Erfassungsspulen (3) jeweils auf beiden Seiten der das magnetische Streufeld übertragenden Spule angeordnet sind.

5. Dynamische aktive Abschirmvorrichtung für magnetisches Streufeld nach Anspruch 1, wobei die Anregungsquelle (5) eine Spannungsquelle und/oder eine Stromquelle umfasst.

6. Dynamisches aktives Kompensationsverfahren für ein magnetisches Streufeld, umfassend die folgenden Schritte:
Erfassen der magnetischen Streufeldintensität um die drahtlose Ladevorrichtung;
Berechnen eines Kompensationswerts für das magnetische Streufeld gemäß der magnetischen Streufeldintensität; und
Beurteilen, ob die erfasste magnetische Streufeldintensität größer als ein Sollwert des magnetischen Streufelds ist, und, wenn die erfasste magnetische Streufeldintensität den Sollwert überschreitet, Erzeugen eines Kompensationsmagnetfelds gemäß dem Kompensationswert für das magnetische Streufeld, um dem magnetischen Streufeld entgegenzuwirken.

7. Dynamisches aktives Kompensationsverfahren für ein magnetisches Streufeld nach Anspruch 6, ferner umfassend: nach dem Erzeugen des Kompensationsmagnetfelds Erfassen der magnetischen Streufeldintensität in Echtzeit und dynamisches Anpassen der Intensität des Kompensationsmagnetfelds gemäß der magnetischen Streufeldintensität.

8. Dynamisches aktives Kompensationsverfahren für ein magnetisches Streufeld nach Anspruch 6, ferner umfassend: Erfassen der magnetischen Streufeldintensität mehrerer Detektionspunkte um die drahtlose Ladevorrichtung, Berechnen eines gewichteten Mittelwerts davon und Verwenden des gewichteten Mittelwerts zum Berechnen des Kompensationswerts für das magnetische Streufeld.

9. Steuervorrichtung, umfassend einen Speicher und einen Prozessor, wobei der Speicher ein Computerprogramm speichert und das Computerprogramm, wenn es durch den Prozessor ausgeführt wird, die Schritte des Verfahrens nach einem der Ansprüche 6-8 ausführt.

10. Computerlesbares Speichermedium zum Speichern von Computeranweisungen, wobei die Anweisungen die Schritte des Verfahrens nach einem der Ansprüche 6-8 implementieren, wenn sie durch einen Computer oder einen Prozessor ausgeführt werden.

## Revendications

1. Dispositif de blindage contre les fuites de flux magnétique actif dynamique, comprenant : une unité de détection de champ magnétique, une source d'excitation (5) et une bobine d'excitation (6), l'unité de détection de champ magnétique étant configurée pour détecter une intensité de champ de fuite de flux magnétique et obtenir une valeur de compensation de champ de fuite de flux magnétique ; et la source d'excitation (5) étant configurée pour exciter la bobine d'excitation (6) afin de générer un champ magnétique de la valeur de compensation pour contrebalancer un champ de fuite de flux magnétique,
l'unité de détection de champ magnétique comprenant une bobine de détection d'intensité de champ magnétique (3) et un microprocesseur (4), la bobine de détection d'intensité de champ magnétique (3) étant configurée pour détecter l'intensité de champ de fuite de flux magnétique, et le microprocesseur (4) étant configuré pour calculer la valeur de compensation de champ de fuite de flux magnétique correspondante en fonction de l'intensité de champ de fuite de flux magnétique détectée,
**caractérisé en ce que**
le microprocesseur (4) est en outre configuré pour juger si l'intensité de champ de fuite de flux magnétique détectée dépasse ou non une valeur définie, et si l'intensité de champ de fuite de flux magnétique détectée dépasse la valeur définie, démarrer la source d'excitation (5) pour exciter la bobine d'excitation (6) afin de générer le champ magnétique de la valeur de compensation pour contrebalancer le champ de fuite de flux magnétique.

2. Dispositif de blindage contre les fuites de flux magnétique actif dynamique selon la revendication 1, lequel le microprocesseur (4) étant en outre configuré pour réaliser un calcul de moyenne pondérée sur l'intensité de champ de fuite de flux magnétique détectée par de multiples points de détection afin d'obtenir la valeur de compensation de champ de fuite de flux magnétique.

3. Dispositif de blindage contre les fuites de flux magnétique actif dynamique selon la revendication 1, au moins une bobine de détection d'intensité de champ magnétique (3) étant agencée au bord d'une bobine de transmission de champ de fuite de flux magnétique.

4. Dispositif de blindage contre les fuites de flux magnétique actif dynamique selon la revendication 3, deux bobines de détection d'intensité de champ magnétique (3) étant respectivement agencées sur les deux côtés de la bobine de transmission de champ de fuite de flux magnétique.

5. Dispositif de blindage contre les fuites de flux magnétique actif dynamique selon la revendication 1, la source d'excitation (5) comprenant une source de tension et/ou une source de courant.

6. Procédé de compensation de champ de fuite de flux magnétique actif dynamique, comprenant les étapes suivantes :
détection de l'intensité de champ de fuite de flux magnétique autour du dispositif de charge sans fil ;
calcul d'une valeur de compensation de champ de fuite de flux magnétique en fonction de l'intensité de champ de fuite de flux magnétique ; et
détermination si l'intensité de champ de fuite de flux magnétique détectée est supérieure à une valeur définie de champ de fuite de flux magnétique, et si l'intensité de champ de fuite de flux magnétique détectée dépasse la valeur définie, génération d'un champ magnétique de compensation en fonction de la valeur de compensation de champ de fuite de flux magnétique pour contrebalancer un champ de fuite de flux magnétique.

7. Procédé de compensation de champ de fuite de flux magnétique actif dynamique selon la revendication 6, comprenant en outre : après la génération du champ magnétique de compensation, la détection de l'intensité de champ de fuite de flux magnétique en temps réel, et l'ajustement dynamique de l'intensité du champ magnétique de compensation en fonction de l'intensité de champ de fuite de flux magnétique.

8. Procédé de compensation de champ de fuite de flux magnétique actif dynamique selon la revendication 6, comprenant en outre : la détection de l'intensité de champ de fuite de flux magnétique de multiples points de détection autour du dispositif de charge sans fil, le calcul d'une moyenne pondérée de celle-ci, et l'utilisation de la moyenne pondérée pour calculer la valeur de compensation de champ de fuite de flux magnétique.

9. Contrôleur, comprenant une mémoire et un processeur, la mémoire stockant un programme informatique, et le programme pouvant mettre en œuvre les étapes du procédé selon l'une quelconque des revendications 6 à 8 lorsqu'il est exécuté par le processeur.

10. Support de stockage lisible par ordinateur pour stocker des instructions informatiques, les instructions mettant en œuvre les étapes du procédé selon l'une quelconque des revendications 6 à 8 lorsqu'elles sont exécutées par un ordinateur ou un processeur.
